(19) Europäisches Patentamt
European Patent Office
Office européen des brevets

(11) **EP 2 950 435 B1**

(12) **FASCICULE DE BREVET EUROPEEN**

(45) Date de publication et mention de la délivrance du brevet:
**04.01.2017 Bulletin 2017/01**

(51) Int Cl.:
***H02M 3/158*** *(2006.01)*    ***H02J 7/32*** *(2006.01)*

(21) Numéro de dépôt: **14169861.3**

(22) Date de dépôt: **26.05.2014**

(54) **Dispositif électronique comprenant un générateur d'énergie à très basse tension alimentant une batterie**

Elektronische Vorrichtung, die einen Energiegenerator mit sehr niedriger Spannung umfasst, der eine Batterie speist

Electronic device including a very-low-voltage power generator supplying a battery

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**02.12.2015 Bulletin 2015/49**

(73) Titulaire: **EM Microelectronic-Marin SA 2074 Marin (CH)**

(72) Inventeurs:
• **Saby, Jérôme**
  **2000 Neuchâtel (CH)**
• **Theoduloz, Yves**
  **1400 Yverdon (CH)**
• **Marti, Cyril**
  **2523 Lignières (CH)**

(74) Mandataire: **Surmely, Gérard et al ICB Ingénieurs Conseils en Brevets SA Faubourg de l'Hôpital 3 2001 Neuchâtel (CH)**

(56) Documents cités:
**WO-A1-2013/042166**

• **PROYNOV P ET AL: "Switched-capacitor power sensing in low-power energy harvesting systems", ELECTRONICS LETTERS, IEE STEVENAGE, GB, vol. 49, no. 2, 17 janvier 2013 (2013-01-17), pages 151-152, XP006044741, ISSN: 0013-5194, DOI: 10.1049/EL.2012.3907**
• **XINPING CAO ET AL: "Electromagnetic Energy Harvesting Circuit With Feedforward and Feedback DC-DC PWM Boost Converter for Vibration Power Generator System", IEEE TRANSACTIONS ON POWER ELECTRONICS, INSTITUTE OF ELECTRICAL AND ELECTRONICS ENGINEERS, USA, vol. 22, no. 2, 22 mars 2007 (2007-03-22), pages 679-685, XP011172355, ISSN: 0885-8993, DOI: 10.1109/TPEL.2006.890009**
• **JUNGMOON KIM ET AL: "A DC DC Boost Converter With Variation-Tolerant MPPT Technique and Efficient ZCS Circuit for Thermoelectric Energy Harvesting Applications", IEEE TRANSACTIONS ON POWER ELECTRONICS, INSTITUTE OF ELECTRICAL AND ELECTRONICS ENGINEERS, USA, vol. 28, no. 8, 28 août 2013 (2013-08-28), pages 3827-3833, XP011488471, ISSN: 0885-8993, DOI: 10.1109/TPEL.2012.2231098**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

Domaine technique

La présente invention concerne le domaine des dispositifs électroniques comprenant une batterie et un générateur d'énergie électrique très basse tension prévu pour recharger la batterie au travers d'un convertisseur DC/DC définissant un élévateur de tension. En particulier, le générateur est un générateur thermoélectrique qui capte de l'énergie thermique dans son environnement. Par exemple, le dispositif électronique est une montre portée au poignet de l'utilisateur.

Arrière-plan technologique

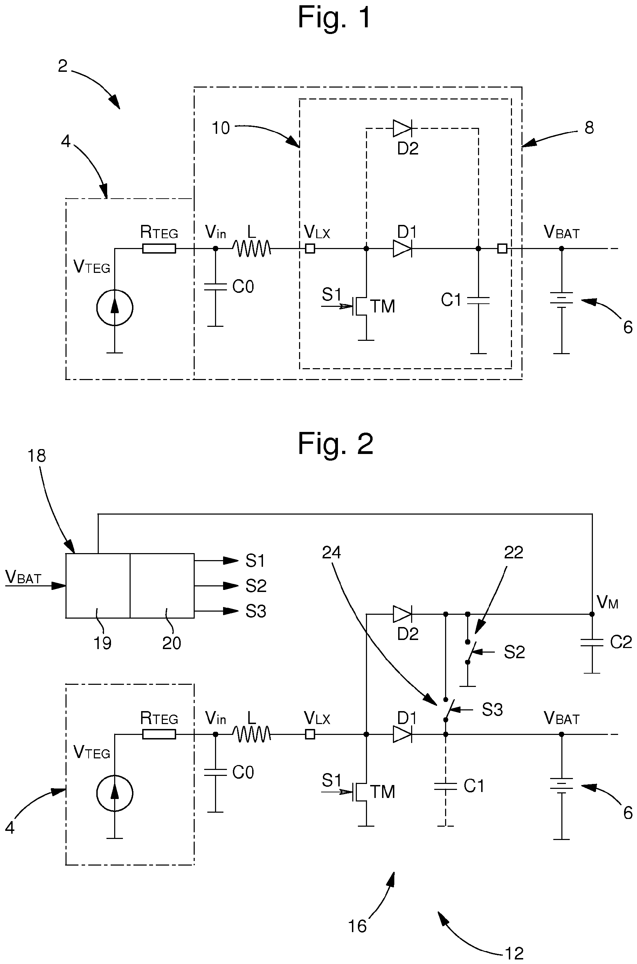

On connaît des générateurs thermoélectriques (TEG de 'Thermal Electrical Generator') qui sont capables de fournir de l'énergie électrique à faible tension, notamment de l'ordre de quelques millivolt, pour charger une batterie d'un dispositif électronique portable au moyen d'un convertisseur élévateur de tension (en anglais 'boost converter') du type inductif. Un schéma électrique d'un tel dispositif est représenté partiellement à la Figure 1.

Le document "Electromagnetic Energy harvesting Circuit with Feedforward and Feedback DC-DC PWM boost converter for Vibration power Harvesting" (IEEE Transactions on power electronics, Xinping Cao and al) divulgue un tel générateur couplé à un convertisseur boost.

Le dispositif électronique 2 comprend un générateur thermoélectrique 4, schématisé par une source de tension $V_{TEG}$ et une tension interne $R_{TEG}$, une batterie 6 et un élévateur de tension 8. Cet élévateur de tension est formé par une capacité tampon C0 en entrée, une inductance L et un circuit intégré 10 agencé entre la borne de sortie $V_{LX}$ de l'inductance et la borne positive $V_{BAT}$ de la batterie. On notera que la capacité tampon et l'inductance sont des éléments discrets. Le circuit intégré comprend une diode D1 ou une pluralité de diodes D1, D2 agencée(s) en parallèle entre la borne $V_{LX}$ et la borne positive de la batterie, une capacité de lissage C1 et un interrupteur TM formé par un transistor MOS. Cet interrupteur reçoit un signal de commande S1 d'une unité de commande (non représentée) pour gérer son actionnement. Lorsque le générateur 4 fournit suffisamment d'énergie, la batterie est chargée en commutant périodiquement l'interrupteur TM entre sa position fermée (transistor conducteur) et sa position ouverte (transistor non conducteur).

Pour des générateurs thermoélectriques qui captent une énergie thermique dans leur environnement en présence d'un petit différentiel de température, la tension fournie varie en fonction de ce différentiel de température de sorte que cette tension peut diminuer en-dessous d'une valeur minimale pour laquelle le rendement du système de charge de la batterie devient nul.

Ainsi, en dessous de cette valeur minimale, il faut désactiver l'élévateur de tension pour éviter de décharger la batterie. Pour ce faire, il est nécessaire de mesurer périodiquement la tension en entrée de l'élévateur de tension. Ceci pose un problème technique lorsque la tension $V_{in}$ fournie par le générateur thermoélectrique en fonctionnement normal est très faible, de l'ordre de quelques millivolts (mV), et que ladite valeur minimale est par exemple environ égale 1 mV. Une telle situation se présente par exemple pour une montre portée au poignet d'un utilisateur incorporant un générateur thermoélectrique classique qui fournit une tension entre 5 mV à 10 mV par degré (5-10 mV/K). La différence de température exploitable est de l'ordre du degré Kelvin lorsque la montre est portée au poignet de l'utilisateur. Par contre, lorsque la montre est enlevée du poignet de l'utilisateur et rangée par exemple dans un coffret, la tension fournie devient nulle et il faut donc absolument désactiver le système de captage d'énergie qui consomme et décharge alors la batterie.

Le problème technique relève de la difficulté de mesurer d'aussi petites tensions ou petits courants correspondants. En effet, les circuits électroniques de l'art antérieur pour mesurer de telles petites tensions sont complexes et sensibles, et donc coûteux et difficiles à implémenter.

Résumé de l'invention

La présente invention a pour but d'apporter une solution au problème susmentionné en proposant un circuit de mesure d'une faible tension fournie par un générateur d'énergie électrique, associé à un élévateur de tension du type inductif, qui soit simple et peu onéreux tout en permettant une mesure suffisamment précise de cette faible tension au moins dans une plage de tension utile.

A cet effet, la présente invention a pour objet un dispositif électronique du type décrit précédemment et caractérisé en ce qu'il comprend un circuit de mesure de la tension du générateur d'énergie électrique, ce circuit étant formé par :

- une capacité de mesure agencée en parallèle de la batterie entre la borne de terre et la borne de sortie de l'inductance, cette capacité de mesure étant plus petite que la capacité de la batterie et présentant une borne de mesure reliée à un circuit de mesure de tension;

- une diode située entre la borne de sortie de l'inductance et la borne de mesure de la capacité de mesure; et

- un interrupteur de décharge de la capacité de mesure qui est agencé entre la borne de mesure et la borne de terre et commandé par une unité de commande.

L'unité de commande est agencée pour activer périodiquement un mode de mesure d'une tension à la borne de mesure dans lequel cette unité de commande ferme l'interrupteur de décharge pour un premier intervalle de temps, de manière à vider la capacité de mesure, et ferme l'interrupteur de l'élévateur de tension pour un deuxième intervalle de temps de manière à établir un courant de mesure dans son inductance. Il est prévu que la fin du premier intervalle de temps intervienne avant ou simultanément à la fin du deuxième intervalle de temps, de sorte que l'énergie accumulée dans l'inductance est transférée partiellement dans la capacité de mesure suite au deuxième intervalle de temps et génère ainsi à la borne de mesure, à la fin du transfert d'énergie, une tension représentative de la tension du générateur tant que cette tension est inférieure à la tension de la batterie. La capacité de mesure est sélectionnée de manière que la tension de mesure soit supérieure à la tension du générateur et inférieure à la tension de la batterie pour une tension minimale du générateur permettant une charge de la batterie.

En particulier, le générateur est un générateur thermoélectrique et le dispositif électronique est un objet portable au poignet d'un utilisateur, ce générateur thermoélectrique captant de l'énergie produite par le corps de cet utilisateur.

D'autres caractéristiques particulières de l'invention seront exposées ci-après dans la description détaillée de l'invention.

Brève description des dessins

L'invention sera décrite ci-après à l'aide de dessins annexés, donnés à titre d'exemples nullement limitatifs, dans lesquels :

- La Figure 1, déjà décrite, est le schéma électrique d'un dispositif électronique de l'art antérieur pour charger une batterie à l'aide d'un générateur thermoélectrique fournissant une faible tension ; et
- La Figure 2 est un schéma électrique d'un mode de réalisation d'un dispositif électronique de la présente invention.

Description détaillée de l'invention

Le dispositif électronique 12 représenté à la Figure 2 comprend une batterie 6, un générateur d'énergie électrique 4 et, entre le générateur et la batterie, un convertisseur élévateur de tension du type inductif 16. Le générateur est capable de fournir en entrée du convertisseur élévateur de tension une tension $V_{in}$ qui est inférieure à une tension $V_{BAT}$ délivrée par la batterie.

Le convertisseur élévateur de tension 16 comprend :

- une inductance L ayant sa borne d'entrée reliée au générateur 4,
- au moins une première diode D1 agencée entre la borne de sortie $V_{LX}$ de l'inductance et la borne d'alimentation de la batterie 6,
- un premier interrupteur TM agencé entre la borne de sortie de l'inductance et une borne de terre, et
- une unité de commande 20 qui commande le premier interrupteur en lui fournissant un signal de commande S1.

De plus, selon l'invention, le dispositif électronique 12 comprend en outre un circuit de mesure de la tension $V_{in}$ fournie par le générateur. Ce circuit de mesure est formé par :

- une capacité de mesure C2 agencée en parallèle de la batterie entre une borne de terre et la borne de sortie de l'inductance, cette capacité de mesure étant inférieure à la capacité de la batterie et présentant une borne de mesure reliée à un circuit de mesure 19 de la tension à cette borne de mesure,
- une deuxième diode D2 située entre la borne de sortie $V_{LX}$ de l'inductance et la borne de mesure de la capacité de mesure, et
- un deuxième interrupteur 22 agencé entre la borne de mesure et une borne de terre et commandé par l'unité de commande 20 qui lui fournit un signal de commande S2.

Le circuit de mesure 19 et l'unité de commande 20 forment ensemble un circuit de gestion 18 de la charge de la batterie 6 par le générateur 4. Dans le mode de réalisation décrit ici, le générateur est un générateur thermoélectrique. Le circuit de gestion 18 est agencé pour activer périodiquement un mode de mesure de la tension $V_M$, à la borne de mesure de la capacité C2, dans lequel l'unité de commande 20 ferme le deuxième interrupteur 22 pour un premier intervalle de temps, de manière à vider la capacité C2, et ferme le premier interrupteur TM pour un deuxième intervalle de temps de manière à établir un courant de mesure dans l'inductance. La fin du premier intervalle de temps intervient avant ou simultanément à la fin du deuxième intervalle de temps de sorte que l'énergie accumulée dans l'inductance est transférée partiellement dans la capacité de mesure C2 suite au deuxième intervalle de temps et génère ainsi à la borne de mesure de cette capacité, à la fin du transfert d'énergie, une tension $V_M$ représentative de la tension $V_{in}$ tant que cette tension $V_M$ est inférieure à la tension $V_{BAT}$ de la batterie. La capacité de mesure est sélectionnée de manière que la tension $V_M$ soit supérieure à la tension $V_{in}$ et inférieure à la tension de la batterie pour au moins une tension minimale du générateur 4 permettant une charge de la batterie.

Dans une variante principale, la tension $V_{in}$ fournie par le générateur 4 est très faible, inférieure à 100 mV. Par exemple, la tension fournie par un générateur thermoélectrique dans un dispositif portable est d'environ 5 mV. La batterie est prévue pour fournir une tension de l'ordre du Volt, par exemple 1,5 V.

L'énergie accumulée dans une inductance L traversée par un courant $I_L$ est égale à

$$E_L = \frac{1}{2} L \cdot I_L{}^2$$

Cette énergie est transférée à la capacité de mesure C2 (valeur de cette capacité égale à C) avec une perte égale à la moitié par dissipation d'énergie. L'énergie stockée dans la capacité C2 et l'énergie dissipée lors du transfert entre l'inductance et cette capacité est égale à

$$E_C = C(Vin)^2$$

Dans une variante préférée, telle que représentée à la Figure 2, le dispositif électronique 12 comprend une capacité tampon C0 agencée entre la borne d'entrée de l'inductance et la borne de terre. Dans le mode de mesure de $V_{in}$, l'unité de commande 20 maintient ouvert le premier interrupteur TM durant un troisième intervalle de temps $T_{init}$ précédant ledit deuxième intervalle de temps et dont la durée est prévue suffisamment longue pour que la tension $V_{in}$ à la borne d'entrée de l'inductance L ait une valeur au moins égale à 90% de la tension interne $V_{TEG}$ du générateur 4. Pour le cas défavorable où C0 serait initialement vide, on obtient cette charge de C0 à au moins 90% avec $T_{INIT} = 3 \cdot R_{TEG} \cdot C0$.

Dans une variante préférée, la capacité tampon C0 conserve approximativement une tension constante à la borne d'entrée de l'inductance durant tout le deuxième intervalle de temps au cours duquel le premier interrupteur est fermé pour établir un courant dans l'inductance, ce courant dépendant linéairement de la tension $V_{TEG}$ générée par le générateur thermoélectrique. En particulier, le deuxième intervalle $T_{TM}$ et la capacité tampon C0 sont sélectionnés de manière que la tension $V_{in}$ à la borne d'entrée de l'inductance diminue au plus de 10% au cours du deuxième intervalle. A titre d'exemple, $V_{TEG}$ = 1 mV, C0 = 10 $\mu$F, L = 100 $\mu$H et $T_{TM}$ = 100 $\mu$s.

Les conditions des variantes préférées mentionnées ci-avant permettent d'approximer la valeur de la tension $V_M$ de la capacité de mesure C2 par une relation mathématique correspondant à un cas idéal avec $V_{in}$ = $V_{TEG}$ pendant tout le deuxième intervalle de temps $T_{TM}$ où le premier interrupteur TM est fermé (c'est-à-dire conducteur) dans le mode de mesure. Dans ce cas idéal, le courant $I_L$ circulant dans l'inductance L est donné par la formule suivante:

$$I_L = (V_{TEG} \times T_{TM})/L$$

En égalant l'énergie $E_L$ avec l'énergie $E_C$ dans les deux égalités données précédemment, on obtient une valeur théorique pour $V_M$ donnée par l'égalité suivante:

$$V_M = (V_{TEG} \times T_{TM})/\sqrt{2LC}$$

Dans un exemple de réalisation avec $V_{TEG}$ = 1 mV, L = 100 $\mu$H et $T_{TM}$ = 100 $\mu$s mentionnées ci-dessus et C = 100 pF, on obtient pour $V_M$ une valeur sensiblement égale à 700 mV (0,7 V). On remarquera que, si la tension de batterie est égale par exemple à 1,5 V, la tension de $V_{TEG}$ ne pourra plus être mesurée correctement dès que cette tension dépasse sensiblement 2 mV. Ainsi le circuit de mesure selon l'invention a une application limitée, mais spécifique à l'application prévue pour ce circuit de mesure, à savoir de déterminer si le générateur génère une tension minimale suffisante à une charge de la batterie, c'est-à-dire avec un bilan énergétique positif. On comprend donc que le générateur peut fournir en fonctionnement normal une tension plus élevée, par exemple une tension dans la plage 5-10 mV. Dans cette plage, le circuit de mesure ne permet pas de mesurer la tension du générateur. Par contre, il permet de détecter que cette tension est supérieure à une certaine valeur, ici 2 mV, lorsque le générateur fonctionne dans ladite plage. Si la tension minimale pour $V_{TEG}$ est égale par exemple à 1 mV, la tension de mesure correspondante reste en-dessous de 1 V, mais supérieure à 0,5 V. La mesure d'une telle tension par le circuit de mesure 19 est aisée et demande un circuit simple et peu coûteux, d'autant plus qu'il n'a pas besoin d'être très précis. De préférence, l'inductance, la capacité de mesure et la durée du deuxième intervalle de temps $T_{TM}$ sont sélectionnées de manière que la tension de mesure $V_M$ soit au moins cent fois supérieure à la tension fournie par le générateur.

Selon une variante particulière, la tension de seuil de la deuxième diode D2 est supérieure à la tension $V_{TEG}$ fournie par le générateur. Par exemple, cette tension de seuil est égale à 200 mV. Cette caractéristique permet d'éviter que la capacité C0 charge la capacité C2 à une tension initiale sensiblement égale à $V_{TEG}$ lors d'une mesure de cette tension. On notera cependant qu'une telle tension initiale ne perturberait quasi pas la mesure étant donné la faible valeur de $V_{TEG}$ et que la charge de C2 n'influencerait quasi pas la charge de la capacité tampon C0.

Selon une variante particulière, un troisième interrupteur 24 est agencé entre la borne de mesure et la borne d'alimentation de la batterie. Ce troisième interrupteur est également commandé par l'unité de commande 20 qui lui fournit un signal de commande S3. L'unité de commande est agencée de manière à fermer ce troisième interrupteur dans un mode de charge de la batterie et à l'ouvrir dans le mode de mesure. Un premier avantage de cette variante provient du fait que la diode D2 forme un élément utile du circuit de charge de la batterie. En d'autres termes, cette diode D2 n'est pas une diode additionnelle propre au circuit de mesure de la tension du générateur ; mais elle a une première fonction en mode de charge où elle permet de former un chemin de charge de la batterie parallèle à celui passant par la première diode D1 ; et elle a une deuxième fonction en mode de mesure où elle permet de décharger initialement la capacité de mesure et ensuite de conserver l'énergie transférée de l'inductance à cette capacité de mesure. De plus, le troisième interrupteur, lorsqu'il est fermé (c'est-à-dire conducteur), permet d'utiliser la capacité C2 comme capacité de lissage pour la charge de la batterie. Ainsi, la capacité de lissage C1 est optionnelle dans certaines réalisations, comme représenté à la Figure 2.

## Revendications

1.  Dispositif électronique comprenant une batterie (6), un générateur d'énergie électrique (4) et, entre le générateur et la batterie, un convertisseur élévateur de tension du type inductif (16), ce générateur étant capable de fournir une première tension ($V_{in}$) inférieure à une deuxième tension ($V_{BAT}$) délivrée par la batterie, ce convertisseur comprenant :

    - une inductance (L) ayant sa borne d'entrée reliée au générateur,
    - au moins une première diode (D1) agencée entre la borne de sortie de l'inductance et la borne d'alimentation de la batterie,
    - un premier interrupteur (TM) agencé entre la borne de sortie de l'inductance et une borne de terre, et
    - une unité de commande (20) agencée pour commander le premier interrupteur ;

    **caractérisé en ce que** ce dispositif électronique comprend en outre un circuit de mesure de ladite première tension qui est formé par :

    - une capacité de mesure (C2) agencée en parallèle de la batterie entre la borne de terre et la borne de sortie de l'inductance, cette capacité de mesure étant plus petite que la capacité de la batterie et présentant une borne de mesure reliée à un circuit de mesure de tension (19),
    - une deuxième diode (D2) située entre la borne de sortie de l'inductance et la borne de mesure de la capacité de mesure, et
    - un deuxième interrupteur (22) agencé entre ladite borne de mesure et la borne de terre et commandé par l'unité de commande;

    l'unité de commande étant agencée pour activer périodiquement un mode de mesure d'une tension ($V_M$) à ladite borne de mesure dans lequel cette unité de commande ferme le deuxième interrupteur pour un premier intervalle de temps, de manière à vider la capacité de mesure, et ferme le premier interrupteur pour un deuxième intervalle de temps de manière à établir un courant de mesure dans l'inductance, la fin du premier intervalle de temps intervenant avant ou simultanément à la fin du deuxième intervalle de temps de sorte que l'énergie accumulée dans l'inductance est transférée partiellement dans la capacité de mesure suite au deuxième intervalle de temps et génère ainsi à ladite borne de mesure à la fin du transfert d'énergie une tension représentative de ladite première tension tant que cette tension est inférieure à la tension de la batterie, la capacité de mesure étant sélectionnée de manière que la tension de mesure soit supérieure à la première tension et inférieure à la tension de la batterie pour une tension minimale dudit générateur permettant une charge de la batterie.

2.  Dispositif électronique selon la revendication 1, **caractérisé en ce qu'**il comprend une capacité tampon (C0) agencée entre la borne d'entrée de l'inductance et la borne de terre ; et **en ce que** ladite unité de commande, dans ledit mode de mesure, maintient ouvert le premier interrupteur (TM) durant un troisième intervalle de temps précédant ledit deuxième intervalle de temps, la durée du troisième intervalle de temps étant prévue suffisamment longue pour que la tension à la borne d'entrée de l'inductance ait une valeur au moins égale à 90% de la première tension du générateur.

3.  Dispositif électronique selon la revendication 2, **caractérisé en ce que** la durée du deuxième intervalle et ladite capacité tampon sont sélectionnées de manière que la tension à ladite borne d'entrée diminue au plus de 10% au cours dudit deuxième intervalle.

4.  Dispositif électronique selon l'une quelconque des revendications précédentes, **caractérisé en ce que** la tension de seuil de la deuxième diode est supérieure à la première tension fournie par le générateur.

5.  Dispositif électronique selon l'une quelconque des revendications précédentes, **caractérisé en ce qu'**un troisième interrupteur (24) est agencé entre ladite borne de mesure et la borne d'alimentation de la batterie, ce troisième interrupteur étant également commandé par l'unité de commande, cette dernière étant agencée de manière à fermer ce troisième interrupteur dans un mode de charge de la batterie et à l'ouvrir dans ledit mode de mesure.

6.  Dispositif électronique selon l'une quelconque des revendications précédentes, **caractérisé en ce que** l'inductance, la capacité de mesure et la durée du deuxième intervalle de temps sont sélectionnées de manière que la tension de mesure soit, au moins pour ladite tension minimale, au moins cent fois supérieure à la première tension fournie par le générateur.

7. Dispositif électronique selon l'une quelconque des revendications précédentes, **caractérisé en ce que** ledit générateur est un générateur thermoélectrique et ce dispositif électronique est un objet portable au poignet d'un utilisateur, ce générateur thermoélectrique captant de l'énergie produite par le corps de cet utilisateur.

## Patentansprüche

1. Elektronische Vorrichtung, die eine Batterie (6), einen Generator (4) für elektrische Energie und zwischen dem Generator und der Batterie einen Spannungs-Aufwärtswandler (16) des induktiven Typs umfasst, wobei dieser Generator eine erste Spannung ($V_{in}$) liefern kann, die kleiner als eine von der Batterie gelieferte zweite Spannung ($V_{BAT}$) ist, wobei dieser Wandler Folgendes umfasst:

   - eine Induktivität (L), die mit ihrem Eingangsanschluss mit dem Generator verbunden ist,
   - wenigstens eine erste Diode (D1), die zwischen dem Ausgangsanschluss der Induktivität und dem Versorgungsanschluss der Batterie angeordnet ist,
   - einen ersten Schalter (TM), der zwischen dem Ausgangsanschluss der Induktivität und einem Masseanschluss angeordnet ist, und
   - eine Steuereinheit (20), die dafür ausgelegt ist, den ersten Schalter zu steuern,

   **dadurch gekennzeichnet, dass** diese elektronische Vorrichtung außerdem eine Schaltung zum Messen der ersten Spannung umfasst, die gebildet ist durch:

   - eine Messkapazität (C2), die zwischen dem Masseanschluss und dem Ausgangsanschluss der Induktivität parallel zu der Batterie angeordnet ist, wobei diese Messkapazität kleiner als die Kapazität der Batterie ist und einen Messanschluss aufweist, der mit einer Spannungsmessschaltung (19) verbunden ist,
   - eine zweite Diode (D2), die sich zwischen dem Ausgangsanschluss der Induktivität und dem Messanschluss der Messkapazität befindet, und
   - einen zweiten Schalter (22), der zwischen dem Messanschluss und dem Masseanschluss angeordnet ist und durch die Steuereinheit gesteuert wird;

   wobei die Steuereinheit dafür ausgelegt ist, periodisch eine Betriebsart zum Messen einer Spannung ($V_M$) an dem Messanschluss zu aktivieren, in der diese Steuereinheit den zweiten Schalter für ein erstes Zeitintervall schließt, derart, dass die Messkapazität geleert wird, und den ersten Schalter für ein zweites Zeitintervall schließt, derart, dass in der Induktivität ein Messstrom erzeugt wird, wobei das Ende des ersten Zeitintervalls vor oder gleichzeitig mit dem Ende des zweiten Zeitintervalls eintritt, derart, dass die in der Induktivität gespeicherte Energie nach dem zweiten Zeitintervall teilweise in die Messkapazität übertragen wird und somit an dem Messanschluss am Ende der Energieübertragung eine Spannung erzeugt, die die erste Spannung darstellt, solange diese Spannung niedriger als die Spannung der Batterie ist, wobei die Messkapazität in der Weise gewählt ist, dass bei einer minimalen Spannung des Generators, die ein Laden der Batterie ermöglicht, die Messspannung höher als die erste Spannung und niedriger als die Spannung der Batterie ist.

2. Elektronische Vorrichtung nach Anspruch 1, **dadurch gekennzeichnet, dass** sie eine Pufferkapazität (C0) umfasst, die zwischen dem Eingangsanschluss der Induktivität und dem Masseanschluss angeordnet ist; und dass die Steuereinheit in der Messbetriebsart den ersten Schalter (TM) für ein drittes Zeitintervall, das dem zweiten Zeitintervall vorhergeht, geöffnet hält, wobei die Dauer des dritten Zeitintervalls ausreichend lang vorgesehen ist, damit die Spannung am Eingangsanschluss der Induktivität einen Wert hat, der wenigstens gleich 90 % der ersten Spannung des ersten Generators ist.

3. Elektronische Vorrichtung nach Anspruch 2, **dadurch gekennzeichnet, dass** die Dauer des zweiten Intervalls und die Pufferkapazität in der Weise gewählt sind, dass die Spannung an dem Eingangsanschluss während des zweiten Intervalls höchstens um 10 % abnimmt.

4. Elektronische Vorrichtung nach einem der vorhergehenden Ansprüche, **dadurch gekennzeichnet, dass** die Schwellenspannung der zweiten Diode größer als die von dem Generator gelieferte erste Spannung ist.

5. Elektronische Vorrichtung nach einem der vorhergehenden Ansprüche, **dadurch gekennzeichnet, dass** zwischen dem Messanschluss und dem Versorgungsanschluss der Batterie ein dritter Schalter (24) angeordnet ist, wobei dieser dritte Schalter ebenfalls durch die Steuereinheit gesteuert wird, wobei diese Letztere ausgelegt ist, diesen dritten Schalter in einer Betriebsart zum Laden der Batterie zu schließen und in der Messbetriebsart zu öffnen.

6. Elektronische Vorrichtung nach einem der vorhergehenden Ansprüche, **dadurch gekennzeichnet, dass** die Induktivität, die Messkapazität und die Dauer des zweiten Zeitintervalls in der Weise gewählt sind, dass die Messspannung zumindest für die minimale Spannung zumindest hundert Mal größer ist als die erste Spannung, die von dem Generator geliefert wird.

7. Elektronische Vorrichtung nach einem der vorhergehenden Ansprüche, **dadurch gekennzeichnet, dass** der Generator ein thermoelektrischer Generator ist und dass diese elektronische Vorrichtung ein am Handgelenk eines Anwenders tragbarer Gegenstand ist, wobei dieser thermoelektrische Generator die vom Körper dieses Anwenders erzeugte Energie aufnimmt.

**Claims**

1. Electronic device including a battery (6), an electrical energy generator (4) and, between the generator and the battery, an inductive voltage boost converter (16), said generator being capable of supplying a first voltage ($V_{in}$) lower than a second voltage ($V_{BAT}$) supplied by the battery, said converter including:

 - an inductor (L) whose input terminal is connected to the generator,
 - at least a first diode (D1) arranged between the inductor output terminal and the battery power supply terminal,
 - a first switch (TM) arranged between the inductor output terminal and an earth terminal, and
 - a control unit (20) arranged to control the first switch;

 **characterized in that** said electronic device further includes a circuit for measuring said first voltage, which is formed by:

 - a measuring capacitor (C2) arranged in parallel with the battery between the earth terminal and the inductor output terminal, said measuring capacitor being smaller than the battery capacitor and having a measuring terminal connected to the voltage measuring circuit (19);
 - a second diode (D2) located between the inductor output terminal and the measuring terminal of the measuring capacitor; and
 - a second switch (22) arranged between said measuring terminal and an earth terminal and controlled by the control unit;

 the control unit being arranged to periodically activate a mode for measuring a voltage ($V_M$) at said measuring terminal wherein said control unit closes the second switch for a first time interval, so as to empty the measuring capacitor, and closes the first switch for a second time interval so as to establish a measuring current in the inductor, the end of the first time interval occurring before or simultaneously with the end of the second time interval so that the energy accumulated in the inductor is partially transferred into the measuring capacitor after the second time interval and thus generates, at said measuring terminal, at the end of the energy transfer, a voltage representative of said first voltage as long as said voltage is less than the battery voltage, the measuring capacitor being selected so that the measuring voltage is higher than the first voltage and lower than the battery voltage at a minimum voltage of said generator allowing charging of the battery.

2. Electronic device according to claim 1, **characterized in that** the device includes a buffer capacitor (C0) arranged between the inductor input terminal and the earth terminal; and **in that** said control unit, in said measuring mode, keeps the first switch (TM) open during a third time interval preceding said second time interval, the duration of the third time interval being arranged to be sufficiently long for the voltage at the inductor input terminal to have a value at least equal to 90% of the first generator voltage.

3. Electronic device according to claim 2, **characterized in that** the duration of the second interval and said buffer capacitor are selected such that the voltage at said input terminal decreases by no more than 10% during said second interval.

4. Electronic device according to any of the preceding claims, **characterized in that** the threshold voltage of the second diode is higher than the first voltage supplied by the generator.

5. Electronic device according to any of the preceding claims, **characterized in that** a third switch (24) is arranged between said measuring terminal and the battery power supply terminal, said third switch also being controlled by the control unit, said control unit being arranged to close said third switch in a battery charging mode and to open said third switch in said measuring mode.

6. Electronic device according to any of the preceding claims, **characterized in that** the inductor, the measuring capacitor and the duration of the second time interval are selected such that the measuring voltage is, at least for said minimum voltage, at least one hundred times higher than the first voltage supplied by the generator.

7. Electronic device according to any of the preceding claims, **characterized in that** said generator is a thermoelectric generator and said electronic device is a portable object worn on a user's wrist, said thermoelectric generator capturing the energy produced by the user's body.

# Fig. 1

# Fig. 2